# EUROPÄISCHE PATENTSCHRIFT

(11) **EP 0 954 075 B1**
(45) Veröffentlichungstag und Bekanntmachung des Hinweises auf die Patenterteilung: **24.08.2005**
(21) Anmeldenummer: 99108123.3
(22) Anmeldetag: 24.04.1999
(51) Int. Cl.: H02B 1/34

(54) **Gerätegriff**
Handle for apparatus
Poignée d'appareil

(30) Priorität: 28.04.1998 DE 29807649 U
(43) Veröffentlichungstag der Anmeldung: 03.11.1999
(73) Patentinhaber: apra-gerätebau Dipl.-Ing.(FH) Wolgang Appenzeller und Wilfried Rademacher GmbH & Co.KG, 54550 Daun/Vulkaneifel (DE)
(72) Erfinder: Appenzeller, Wolfgang, 54550 Daun (DE)
(74) Vertreter: Boecker, Joachim

(56) Entgegenhaltungen:
- DE-U- 29 620 934

## Beschreibung

Die Erfindung betrifft einen Gerätegriff gemäß dem Oberbegriff des Anspruches 1. Bei den Geräten handelt es sich vorzugsweise um elektronische und andere elektrotechnische Geräte.

Geräte der vorgenannten Art werden häufig in Aufnahmegestelle eingebaut. Hierbei handelt es sich vorzugsweise um Aufnahmegestelle mit genormten Abmessungen, beispielsweise mit Abmessungen gemäß der sogenannten 19-Zoll-Technik. Die Frontplatten dieser Geräte sind ebenfalls in ihren Abmessungen weitgehend der Norm angepaßt. Jedoch sind die Schraubenlöcher zur Befestigung von Handgriffen an den Frontplatten der Geräte häufig nicht bei allen Geräten im gleichen Abstand von den seitlichen (vertikalen) Rändern der Frontplatten vorgesehen. Dies hat zur Folge, daß die Handgriffe der Geräte nach dem Einbau der Geräte in das Aufnahmegestell nicht in senkrechter Richtung fluchten, was zu einer unerwünschten Behinderung der Zugänglichkeit und Ausnutzbarkeit des Raumes vor den Geräten durch die Gerätegriffe führen kann.

Aus der DE-U1-29 620 934 ist ein Türgriff bekannt, zu dem eine Betätigungsstange gehört, deren Griffstützen, die die Betätigungsstange mit dem Türblatt verbinden, aus je einem Zwischenstück, das senkrecht zur Bestätigungsstange und parallel zum Türblatt verläuft, und je einer Befestigungsstange bestehen, die senkrecht am Türblatt befestigt ist und deren freies Ende mit dem freien Ende des Zwischenstückes verbunden ist. Ziel des bekannten Türgriffes ist es, diesen nach außen frei von sichtbaren Schraubverbindungen zu halten. Zu diesem Zweck wird mindestens eines der beide Enden der Zwischenstücks mit seinem angrenzenden Teil, also der Betätigungsstange oder der Befestigungsstange, durch Kleben verbunden, während das andere Ende über einen im Innern des Zwischenstücks verlaufenden Zugbolzen mit dem angrenzenden Teil verbunden werden kann. Bei diesem bekannten Türgriff liegen in der sich parallel zum Türblatt erstreckenden vertikalen Ebene, in der die Betätigungsstange liegt, auch die genannten zwischenstücke und die vorderen Enden der genannten Befestigungsstangen.

Der Erfindung liegt die Aufgabe zugrunde, einen Gerätegriff der eingangs genannten Art zu entwickeln, mit dem es möglich ist, trotz der genannten Unregelmäßigkeit der Befestigungslöcher für die Gerätegriffe die räumliche Behinderung durch diese Unregelmäßigkeit zu vermindern.

Zur Lösung dieser Aufgabe wird ein Gerätegriff gemäß dem Oberbegriff des Anspruches 1 vorgeschlagen, welcher erfindungsgemäß die im kennzeichnenden Teil des Anspruches 1 genannten Merkmale hat.

Weitere Ausgestaltungen der Erfindung sind in den Unteransprüchen genannt.

Anhand des in den Figuren gezeigten Ausführungsbeispiels eines Gerätegriffes gemäß der Erfindung soll die Erfindung näher erläutert werden. Es zeigen:
Figur 1 ein Ausführungsbeispiel eines Gerätegriffes gemäß der Erfindung in perspektivischer Darstellung,
Figur 2a eine Ansicht einer Griffstütze gemäß der Erfindung gesehen in Richtung des Pfeiles A in Figur 1,
Figur 2b den Gerätegriff gemäß Figur 2a in Seitenansicht,
Figur 3 den Einbau mehrerer Geräten mit Griffen gemäß der Erfindung in ein Aufnahmegestell.

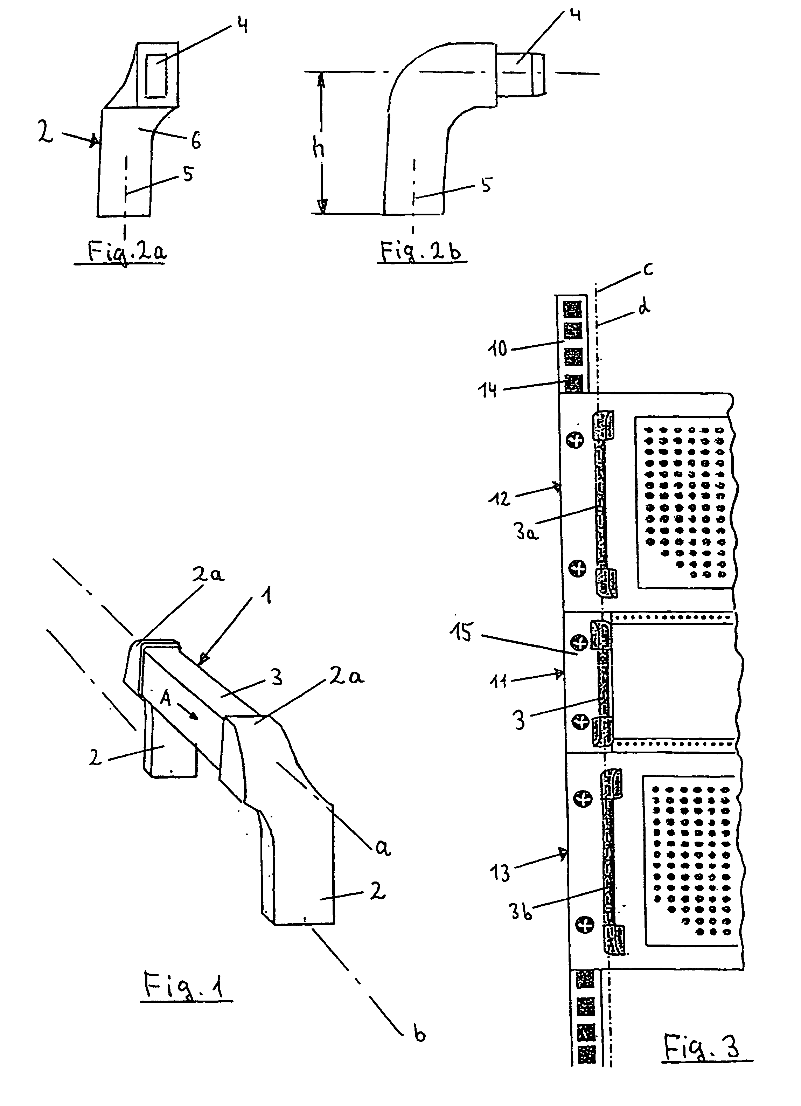

Der in Figur 1 gezeigte Gerätegriff besteht aus zwei Griffstützen 2 und einem Griffstab 1, der zwischen den beiden dem Gerät abgewandten Enden der Griffstützen befestigt ist. Man erkennt, daß die Längsache a des Griffstabes 3 gegenüber den zur Befestigung am Gerät bestimmten Enden, also den Punkten zur Befestigung am Gerät, die auf der Linie b liegen, seitlich versetzt ist.

Die Figuren 2a und 2b zeigen ein Ausführungsbeispiel einer Griffstütze 2 für einen Griff gemäß der Erfindung. Man erkennt, wie der senkrechte Teil 6 der Griffstützen im oberen (dem Gerät abgewandte) Abschnitt zur Seite hin abgekröpft ist. Der Griffstab 3 kann aus einem hohlen Stab bestehen, der auf passende Zapfen 4 an den Griffstützen aufschiebbar ist. Andere Arten der Befestigung zwischen Griffstütze und Griffstab sind möglich; beispielsweise kann umgekehrt der Griffstab mittels Zapfen oder auch mit seinen vollen äußeren Querschnittsabmessungen in eine seitliche Öffnung am oberen Ende der Griffstütze einschiebbar sein. Die Griffstütze 2 ist an ihrer Unterseite mit einem Schraubloch, das in den Figuren 2a und 2b nur durch die gestrichelte Linie 5 angedeutet ist, zur Befestigung an der Frontplatte des Gerätes versehen.

Figur 3 zeigt drei Geräte, die in bekannter Weise in ein Aufnahmegestell 10 eingebaut sind. Die gezeigte, vorzugsweise genormte vertikale Schiene des Aufnahmegestells ist mit Aufnahmelöchern 14 versehen, über welche die seitlich überkragenden Frontplatten 15 der Geräte festgeschraubt sind. Wie die Figur erkennen läßt, haben die zur Befestigung der Handgriffe an den unterschiedlichen Geräten vorgebohrten Löcher, die in der Figur von den Gerätegriffen überdeckt sind, vom seitlichen (vertikalen) Rand der Frontplatten nicht für alle Geräte den gleichen Abstand. Bei Verwendung herkömmlicher, nicht gemäß der Erfindung abgekröpfter Gerätegriffe, würden diese Gerätegriffe daher in vertikaler Richtung nicht miteinander fluchten, wodurch die Ausnutzung des Raumes vor den Frontplatten behindert werden wäre. Durch die Verwendung der Gerätegriffe gemäß der Erfindung wird bei entsprechend bemessener seitlicher Abkröpfung erreicht, daß sämtliche Griffe in vertikaler Richtung fluchten, zumindest jedoch alle in derselben vertikalen Ebene senkrecht zu den Frontplatten 15 der Geräte liegen. Wenn die Griffstützen sämtlicher Handgriffe zugleich die gleiche Höhe h (Figur 2b) haben, dann liegen die Längsachsen der Griffstäbe sämtlicher Geräte in derselben vertikalen Linie.

## Patentansprüche

1. Gerätegriff (1) mit zwei an einem Gerät befestigbaren Griffstützen (2), zwischen deren dem Gerät abgewandten Enden ein Griffstab (3) direkt befestigt ist,
**dadurch gekennzeichnet, daß** die Längsachse (a) des Griffstabes (3) gegenüber der Verbindungslinie (b) zwischen den beiden zur Befestigung am Gerät betimmten Enden (Befestigungspunkten) der Griffstützen (2) derart seitlich versetzt ist, daß in derjenigen Ebene parallel zur Frontplatte des Gerätes, in welcher der Griffstab (3) liegt, nur der unmittelbar den Griffstab haltende Teil (2a) der Griffstützen (2) liegt.

2. Gerätegriff nach Anspruch 1, **dadurch gekennzeichnet, daß** der genannte den Griffstab (3) unmittelbar haltende Teil (2a) der Griffstützen (2) im wesentlichen mit der Längsrichtung (a) des Griffstabes (3) fluchtet.

3. Gerätegriff nach Anspruch 1 oder 2, **dadurch gekennzeichnet, daß** die Griffstützen (2) gekröpft sind.

4. Gerätegriff nach einem der vorhergehenden Ansprüche, **dadurch gekennzeichnet, daß** bei Verwendung des Griffes (1) für ein Gerät (11), das mit anderen Geräten (12,13) in einem vorzugsweise genormten Aufnahmegestell (10) übereinander befestigt ist, die seitliche Versetzung der Längsachse (a) des Griffstabes (3) gegenüber der genannten Verbindungslinie (b) so bemessen ist, daß die genannte Längsachse (a) in einer vorgegebenen vertikalen Ebene (c) senkrecht zur Gerätefront liegt, in der auch die Griffstäbe (3a,3b) der anderen Geräte (12,13) liegen.

5. Gerätegriff nach Anspruch 4, **dadurch gekennzeichnet, daß** die Höhe (h) der Griffstützen so bemessen ist, daß die Längsachse (a) des Griffstabes (3) in einer vorgegebenen vertikalen Linie (d) liegt, in der auch die Längsachsen der Griffstäbe (3a,3b) der anderen Geräte (12,13) liegen.

## Claims

1. Handle (1) for a device which handle comprises two handle supports (2) which are attachable to a device, and a handle bar (3) which is directly secured between those ends of said handle supports which point away from the device, **characterized in that** the longitudinal axis (a) of the handle bar (3) is laterally offset such in relation to the connection line (b) between the two ends of the handle supports destined for attachment to the device (attachment points), that in the plane parallel to the front plate of the device in which the handle bar (3) is positioned, is positioned only that parts (2a) of the handle supports (2) which immediately hold the handle bar.

2. Handle for a device according to claim 1, **characterized in that** said parts (2a) of the handle supports, which immediately hold the handle bar (3), are essentially in alignment with the longitudinal direction (a) of said handle bar (3).

3. Handle for a device according to claim 1 or 2, **characterized in that** the handle supports are cranked.

4. Handle for a device according to any of the preceding claims, **characterized in that**, when using said handle (1) for a device (11) which is mounted along with other devices (12,13) one above another in a preferably standardised reception rack (10), the lateral offset of the longitudinal axis (a) of the handle bar (3) in relation to said connection line (b) is dimensioned such that said longitudinal axis (a) is positioned in a given vertical plane (c) extending perpendicular to the front of the device, in which plane are also positioned the handle bars (3a,3b) of the other devices (12,13).

5. Handle for a device according to claim 4, **characterized in that** the height of said handle supports are dimensioned such that the longitudinal axis (a) of the handle bar (3) is positioned in a given vertical line (d) in which also the longitudinal axes of the handle bars (3a,3b) of the other devices (12,13) are positioned.

## Revendications

1. Poignée (1) d'appareil ayant deux piliers (2) de poignée pouvant être fixée à un appareil et entre les extrémités, éloignées de l'appareil, desquelles est fixée directement une barre (3) de poignée, **caractérisée en ce que** l'axe (a) longitudinal de la barre (3) de poignée est décalée latéralement par rapport à la ligne (b) de liaison entre les deux extrémités (points de fixation), destinées à la fixation sur l'appareil, des piliers (2) de poignée de façon que seule la partie (2a) des piliers (2) de la poignée maintenant directement la barre de la poignée se trouve dans le plan parallèlement à la plaque avant de l'appareil dans lequel se trouve la barre (3) de la poignée.

2. Poignée d'appareil suivant la revendication 1, **caractérisée en ce que** la partie (2a) mentionnée, maintenant directement la barre (3) de la poignée, des piliers (2) de poignée est alignée sensiblement avec la direction (a) longitudinale de la barre (3) de poignée.

3. Poignée d'appareil suivant la revendication 1 ou 2, **caractérisée en ce que** les piliers (2) de la poignée sont coudés.

4. Poignée d'appareil suivant l'une des revendications précédentes, **caractérisée en ce que**, lorsque l'on utilise la poignée (1) pour un appareil (11), qui est fixé à d'autres appareils (12, 13) en superposition dans un bâti (10) de réception, de préférence normé, le décalage latéral de l'axe (a) longitudinal de la barre (3) de la poignée par rapport à ladite ligne (b) de liaison est telle que ledit axe (a) longitudinal se trouve dans un plan (c) vertical donné à l'avance, perpendiculairement à l'avant de l'appareil dans lequel se trouve aussi les barres (3a, 3b) de poignée des autres appareils (12, 13).

5. Poignée d'appareil suivant la revendication 4, **caractérisée en ce que** la hauteur (h) des piliers de poignée est telle que l'axe (a) longitudinal de la barre (a) de la poignée se trouve sur une ligne (d) verticale donnée à l'avance, dans laquelle se trouve aussi les axes longitudinaux des barres (3a, 3b) de poignée des autres appareils (12, 13).
